# EUROPÄISCHE PATENTSCHRIFT

(11) **EP 2 002 493 B1**
(45) Veröffentlichungstag und Bekanntmachung des Hinweises auf die Patenterteilung: **05.06.2013**
(21) Anmeldenummer: 07723392.2
(22) Anmeldetag: 19.03.2007
(51) Int. Cl.: H01L 51/52

(54) **GROSSFLÄCHIGE OLED'S MIT HOMOGENER LICHTEMISSION**
LARGE-AREA OLEDS FEATURING HOMOGENEOUS EMISSION OF LIGHT
DIODES ÉLECTRO-LUMINESCENTES ORGANIQUES À GRANDE SURFACE À ÉMISSION DE LUMIÈRE HOMOGÈNE

(30) Priorität: 05.04.2006 DE 102006016373
(43) Veröffentlichungstag der Anmeldung: 17.12.2008
(73) Patentinhaber: Merck Patent GmbH, 64293 Darmstadt (DE)
(72) Erfinder: FRANK, Thomas, A., 65611 Niederbrechen (DE); HSU, Peter (Fangyun), 65191 Wiesbaden-Sonnenberg (DE); BOEHM, Edgar, 64347 Griesheim (DE); HEINRICH, Anton, Volker, 65205 Wiesbaden (DE)
(86) Internationale Anmeldenummer: PCT/EP2007/002425
(87) Internationale Veröffentlichungsnummer: WO 2007/115651

(56) Entgegenhaltungen:
- EP-A- 1 679 939
- EP-A1- 1 191 823
- JP-A- 2003 045 674
- JP-A- 2003 123 990
- US-A1- 2002 158 835
- US-A1- 2004 174 116
- US-A1- 2005 248 266

## Beschreibung

Die vorliegende Erfindung betrifft großflächige OLED's (Organic Light-Emitting Diodes) mit homogener Lichtemission, Verfahren zu ihrer Herstellung sowie ihre Verwendung.

OLED's haben in den letzten Jahren eine rasante Entwicklung genommen. Sie verdrängen dabei immer mehr die derzeit eingesetzten Flüssigkristalldisplays (LCD's). Gegenüber den LCD's weisen die OLED's mehrere Vorteile auf: Sie zeichnen sich einerseits durch einen einfacheren Aufbau sowie durch einen niedrigeren Energieverbrauch aus. Darüber hinaus weisen sie eine geringere Blickwinkelabhängigkeit auf.

Darüber hinaus zeichnet sich für OLED's als weiteres Einsatzgebiet der Beleuchtungsbereich ab. Sie verdrängen dabei sowohl herkömmliche Leuchtmittel als auch LED's.

Gegenüber herkömmlichen Leuchtmitteln, wie z.B. Glühbirnen und Halogenröhren, zeichnen sich OLED's durch einen sehr viel dünneren Aufbau aus. Darüber hinaus handelt es sich bei OLED's um flächige Leuchtmittel, im Gegensatz zu den punktförmigen, herkömmlichen Leuchtmitteln. Dadurch ist die Verwendung von OLED's in Einsatzgebieten möglich, in denen konventionelle Leuchtmittel nicht eingesetzt werden können.

Im Vergleich zu LED's weisen OLED's eine nahezu Lambert'sche Abstrahlcharakteristik auf, d.h. es müssen nicht wie bei den LED's aufwendige Optiken eingesetzt werden, die einen Punktstrahler in einen Flächenstrahler überführen.

Darüber hinaus ist das elektrolumineszierende Spektrum eines OLED's im Vergleich zu LED's sehr breitbandig. Dies ermöglicht eine große Vielfalt an Farbvariation eines Emitters mittels Farbfiltereinsatz ("Colorbranding"), woraus sich im Beleuchtungsbereich für OLED's ein hohes Potenzial ergibt.

Ferner weisen OLED's den Vorteil auf, dass die Form und Dimension ihrer Leuchtfläche für spezielle Beleuchtungsanwendungen sehr leicht mittels Strukturierung der Anode und/oder der Kathode angepasst werden kann.

Trotz der oben beschriebenen Vorteile der OLED's werden derzeit sowohl im Display-Bereich als auch im Beleuchtungsbereich lediglich OLED's mit sehr kleinen Leuchtflächen eingesetzt. So finden seit geraumer Zeit OLED's beispielsweise in Displays von Handy's und MP3-Playern Verwendung.

Auch wenn OLED's aufgrund ihrer Lambert'schen Abstrahlcharakteristik prinzipiell für große Flächen geeignet sein sollten, und zwar ohne zusätzliche Optik, ist deren Einsatz in Beleuchtungsanwendungen derzeit auf kleine Flächen beschränkt. Derzeit ist es nicht möglich, einzelne OLED's mit einer großen Leuchtfläche bereitzustellen, die über die gesamte Leuchtfläche eine zufriedenstellende Homogenität der Lichtemission aufweisen. Dies ist darauf zurückzuführen, dass die Größe der Leuchtfläche unter anderem durch die Verwendung von ITO ("Indium Tin Oxide") als bevorzugtem, transparentem Anodenmaterial beschränkt wird, da ITO einen-relativ hohen Flächenwiderstand aufweist, was eine homogene Lichtemission auf einer großen Fläche verhindert.

Die Homogenität der Lichtemission kann z.B. durch das Aufbringen einer Hilfselektrode auf die ITO-Elektrode verbessert werden. Eine solche OLED wird in JP2003045674 beschrieben.

Große Flächen können derzeit folglich noch nicht von einem einzigen großen OLED homogen ausgeleuchtet werden. Hierzu müssen im Moment mehrere OLED's entsprechend angeordnet und kontaktiert werden.

Ausgehend von dem oben genannten nächstliegenden Stand der Technik, kann es als Aufgabe der vorliegenden Erfindung angesehen werden, OLED's bereitzustellen, die insbesondere bei großflächiger Ausführung über die gesamte Leuchtfläche eine nahezu homogene Lichtemission ermöglichen.

Gegenstand der vorliegenden Erfindung ist somit ein OLED, vorzugsweise ein großflächiges OLED, das mindestens
- ein Substrat,
- eine Anode mit zwei Zuleitungen,
- mindestens eine organische licht-emittierende Schicht, und
- eine Kathode mit zwei Zuleitungen aufweist,
wobei zumindest entweder
- das Substrat und die Anode
- die Kathode oder
- das Substrat, die Anode und die Kathode transparent sind,
das dadurch gekennzeichnet ist, dass auf der Anode mindestens eine leitende Metallschicht derart angeordnet ist, dass bei der leitenden Metallschicht die Struktur der Kathode ausgespart ist und dass die leitende Metallschicht die Strukur der Kathode im wesentlichen umgibt, wobei die Stellen der zwei Zuleitung der Kathode ausgespart werden und dass anodenseitig direkt an der mindestens einen organischen licht-emittierenden Schicht mindestens eine Lochleiterinjektionsschicht angeordnet ist. Großflächig bedeutet in der vorliegenden Erfindung eine Leuchtfläche von mindestens 1 cm², vorzugsweise mindestens 3 cm². Ab solchen Leuchtflächen spielt die Problematik der Inhomogenität aufgrund des hohen Widerstandes des Elektrodenmaterials eine nicht zu vernachlässigende. Rolle.

Anzumerken ist in diesem Zusammenhang allerdings, dass die Problematik der Inhomogenität auch von der absoluten Leuchtdichte abhängig ist, da aufgrund des Ohmschen Gesetzes bei einem größeren Betreiberstrom der Spannungsabfall über die Elektrodenstrecke proportional zunimmt.

In einer ersten bevorzugten Ausführungsform ("Bottom Emission" OLED) weist das OLED:
ein transparentes Substrat,
eine transparente Anode und
eine Kathode ant.

In einer zweiten bevorzugten Ausführungsform ("Top Emission" OLED) weist das OLED
ein Substrat,
eine Anode und
eine transparente Kathode ant.

In einer dritten bevorzugten Ausführungsform ("transparentes" OLED) weist das OLED:
ein transparentes Substrat,
eine transparente Anode und
eine transparente Kathode ant.

Ganz besonders bevorzugt liegen die zwei Zuleitungen auf gegenüberliegenden Seiten der als Elektrode ausgebildeten Fläche, und zwar insbesondere auf den beiden Seiten, die den größten Abstand voneinander aufweisen. Weist die Kathode zwei Zuleitungen auf, so ergibt sich daraus, dass die auf der Anode angeordnete Metallschicht, bei der die Struktur der Kathode ausgespart ist und die die Struktur der Kathode im wesentlichen umgibt, wobei die Stellen der beiden Zuleitungen der Kathode ausgespart werden, zwei voneinander getrennte Teilflächen aufweist. Folglich weist die Anode ebenfalls zwei Zuleitungen auf, und zwar zu jeder Teilfläche mindestens eine Zuleitung.

Die Kontaktierung des OLED's kann dabei mit allen dem Fachmann bekannten Methoden erfolgen. So ist beispielsweise eine elektrische Fixierung des OLED's ohne eine mechanische Fixierung möglich, beispielsweise mittels FPC ("Flexible Printed Circuit"). In einer weiteren Ausführungsform kann aber auch die Fixierung sowohl elektrisch als auch mechanisch, beispielsweise mittels Stecker, erfolgen.

Besonders bevorzugt ist bei den oben genannten Ausführungsformen auf der Kathode zusätzlich noch eine Verkapselung angeordnet, und zwar auf der, der licht-emittierenden Schicht gegenüberliegenden Seite. In der ersten bevorzugten Ausführungsform ("Bottom Emission" OLED) kann die Verkapselung transparent, semi-transparent sowie nicht transparent sein. In der zweiten sowie dritten bevorzugten Ausführungsform ist die Verkapselung transparent oder semitransparent, vorzugsweise transparent.

Transparent im Sinne der vorliegende Erfindung bedeutet, dass das Material zumindest in Teilbereichen, vorzugsweise jedoch im gesamten Bereich, des sichtbaren Lichtes eine Lichtdurchlässigkeit von > 60 bis 100% aufweist, semi-transparent bedeutet, dass die Lichtdurchlässigkeit im Bereich von 20 bis 60% liegt und nicht transparent bedeutet, dass die Lichtdurchlässigkeit im Bereich von 0 bis < 20% liegt.

Überraschenderweise wurde gefunden, dass es möglich ist, durch die erfindungsgemäße Anordnung der mindestens einen leitenden Schicht, vorzugsweise der mindestens einen Metallschicht, die Homogenität der Lichtemission des OLED's deutlich zu verbessern.

Darüber hinaus lassen sich die erfindungsgemäßen OLED's aufgrund ihrer Anordnung auch unterschiedlich ansteuern, beispielsweise über Einzelansteuerung, Reihenschaltung oder Matrixschaltung.

Als Materialien für die mindestens eine leitende Schicht, die vorzugsweise eine Metallschicht ist, kommen dabei alle dem Fachmann für diesen Zweck geeigneten Materialien in Frage. Bevorzugt als Materialien für die mindestens eine leitende Schicht sind jedoch Edelmetalle, wie zum Beispiel Gold (Au), Silber (Ag) und Kupfer (Cu), es können aber auch leitende Polymere eingesetzt werden. Die leitende Schicht, vorzugsweise die Metallschicht, wird dabei vorzugsweise in Schichtdicken von weniger als 1 µm aufgebracht, um kompatibel für die nachfolgenden Prozesse, wie z. B. Spincoaten, zu bleiben. Unter "leitend" wird in der vorliegenden Anmeldung "den elektrischen Strom leitend" verstanden.

Der Schichtwiderstand der leitenden Schicht, vorzugsweise der Metallschicht, sollte dabei geringer sein als der Schichtwiderstand des eingesetzten Elektrodenmaterials, beispielsweise des vorzugsweise als Anodenmaterial eingesetzten ITO's. Besonders bevorzugt liegt der Schichtwiderstand dabei im Bereich von 1 bis 3 ohm/square. In diesem Zusammenhang ist anzumerken, dass der Schichtwiderstand der leitenden Schicht stark von der späteren Applikation abhängt. Die Schichtdicke der leitenden Schicht ist dabei so einzustellen, dass der geforderte Schichtwiderstand erreicht wird, sich aber kein negativer Einfluß auf die späteren Folgeprozesse ergibt.

In einer besonders bevorzugten Ausführungsform wird als mindestens Metallschicht eine Chrom(Cr)- und eine Kupfer(Cu)-Schicht eingesetzt. Die Dicke der Cr-Schicht liegt dabei vorzugsweise im Bereich von 50 nm. Sie wird hauptsächlich als Haftungsschicht eingesetzt. Die Dicke der Cu-Schicht liegt vorzugsweise im Bereich von 500 nm. Sie hat hauptsächlich die Funktion der leitenden Schicht. Sowohl die Cr- als auch die Cu-Schicht werden dabei vorzugweise mittels Schattenmaske aufgedampft. Auf diese Weise lässt sich ein Schichtwiderstand von etwa 2 ohm/square erreichen.

Als Substrate können alle für diesen Zweck geeigneten Materialien eingesetzt werden. Bevorzugte Substrat-Materialien sind jedoch Glas sowie Kunststoffe, wobei Glas besonders bevorzugt ist. Als Glas können alle möglichen Glassorten eingesetzt werden, wie z.B. typisches Fensterglas. Vorzugsweise werden jedoch Flachgläser eingesetzt, wie sie in der Displayindustrie Verwendung finden (z.B. Kalk-Natron-Glas oder alkalifreies Glas). Als Kunststoffe können alle thermoplastischen Kunststoffe eingesetzt werden, bevorzugt sind jedoch Polymere wie z.B. Polycarbonat (PC), Polymethylmethacrylat (PMMA), Polyvinylcarbazol (PVK), Polybutadiene, Polyethylen (PE), Polyethylenterephthalat (PET) und Polyester. Für "Top Emission" OLED's können auch metallische Substrate, wie z. B. metallische Folien, eingesetzt werden. Die Dicke des Substrates liegt dabei vorzugsweise im Bereich von 0,05 bis 3 mm, besonders bevorzugt im Bereich von 0,2 bis 1,1 mm.

Als Materialien für die vorzugsweise, transparente Anode werden vorzugsweise Indium-Zinn-Oxid (ITO, Indium Tin Oxide) oder auch andere Metalloxide, wie z. B. Indium-Zink-Oxid (IZO) oder Aluminium-Zink-Oxid (AlZnO), aber auch dotierte Versionen der genannten Oxide (z.B. mit Fluor dotiertes ITO) eingesetzt. Darüber hinaus ist auch eine semi-transparente, dünne Metallschicht als Anode oder im Falle des "Top Emission" OLED auch eine nicht-transparente Anode denkbar.

Die organische licht-emittierende Schicht kann als licht-emittierende Materialien entweder sog. "small molecules" (kleine Moleküle) oder Polymere aufweisen. Als Materialien können dabei alle dem Fachmann für diesen Zweck bekannten und geeigneten Materialien eingesetzt werden. Auch ist es möglich, dass bei der Verwendung von mehreren licht-emittierenden Materialien, diese in einer oder mehreren organischen licht-emittierenden Schichten (sog. "multi layers") angeordnet sind.

Darüber hinaus können die erfindungsgemäßen OLED's weitere Funktionsschichten aufweisen, die je nach Anwendung variieren können. So sind beispielsweise Lochleiter-, Elektonenleiter- und/oder Barriereschichten denkbar. Diese können vorzugsweise vorhanden sein, sind jedoch nicht zwingend notwendig.

Die erfindungsgemäßen OLED's weisen mindestens eine Lochleiterinjektionsschicht auf. Diese ist anodenseitig direkt an der mindestens einen licht-emittierenden Schicht angeordnet. Sie kann aus allen dem Fachmann für diesen Zweck geeigneten Materialien bestehen. Bevorzugte Materialien sind jedoch PEDOT (Poly(3,4-ethylendioxythiophen)) und PANI (Polyanilin).

In einer weiteren bevorzugten Ausführungsform weisen die erfindungsgemäßen OLED's mindestens eine Elektronenleiterinjektionsschicht auf. Diese ist kathodenseitig direkt an der mindestens einen licht-emittierenden Schicht angeordnet. Sie kann ebenfalls aus allen dem Fachmann für diesen Zweck geeigneten Materialien bestehen. Bevorzugte Materialien sind jedoch Calcium, Barium und Lithiumfluorid.

Als Materialien für die nicht-transparente oder semi-transparente Kathode werden vorzugsweise metallische Materialien, wie z.B. Al, Ag, Au oder Cr, eingesetzt. In einer besonders bevorzugten Ausführungsform werden Zwei-Schichtsysteme (Bi-layer) aus einer dünnen Schicht Ba, Li, LiF, Ca oder Mg und einer Schicht aus einem Metall aufgedampft. Als Materialien für transparente oder semi-transparente Kathoden, beispielsweise für "Top Emission" OLED's oder transparente OLED's, werden vorzugsweise transparente oder semi-transparente Kathoden-Materialien, wie z.B. ITO, eingesetzt.

Als Verkapselung können alle für diesen Zweck geeigneten Materialien eingesetzt werden. Bevorzugte Verkapselungsmaterialien sind jedoch Glas sowie Kunststoffe, wobei Glas besonders bevorzugt ist. Als Glas können alle möglichen Glassorten eingesetzt werden, wie z.B. typisches Fensterglas. Vorzugsweise werden jedoch Flachgläser eingesetzt, wie sie in der Displayindustrie Verwendung finden (z.B. Kalk-Natron-Glas oder alkalifreies Glas). Besonders bevorzugt werden sog. Aufdampfgläser verwendet, wie sie beispielsweise in der WO 03/088370 A1 offenbart werden. Als Kunststoffe können alle thermoplastischen Kunststoffe eingesetzt werden, bevorzugt sind jedoch Polymere wie z.B. Polycarbonat (PC), Polymethylmethacrylat (PMMA), Polyvinylcarbazol (PVK), Polybutadiene, Polyethylen (PE), Polyethylenterephthalat (PET) und Polyester. Es können jedoch auch metallische Folien als Verkapselung eingesetzt werden. Die Verkapselung kann dabei im einfachsten Fall aus einer einzigen Verkapselungsschicht bestehen, es ist jedoch auch möglich die Verkapselung aus mehreren Schichten aufzubauen. Die Gesamtdicke der Verkapselung liegt dabei vorzugsweise im Bereich von 1 µm bis 3 mm, besonders bevorzugt im Bereich von 5 µm bis 1,1 mm.

Gegenstand der vorliegenden Erfindung ist auch ein Verfahren zur Herstellung der erfindungsgemäßen OLED's, das dadurch gekennzeichnet ist, dass man auf ein Substrat eine Anode mit zwei Zuleitungen, mindestens eine organische licht-emittierende Schicht und eine Kathode mit zwei Zuleitungen aufbringt, das dadurch gekennzeichnet ist, dass man auf der Anode mindestens eine leitende Schicht, die eine Metallschicht ist, derart aufbringt, dass bei der leitenden Schicht die Struktur der Kathode ausgespart ist und das die leitende Schicht die Struktur der Kathode im wesentlichen umgibt, wobei die Stellen der zwei Zuleitungen der Kathode ausgespart werden und dass man anodenseitig direkt ant der mindestens einen organischen licht-emittierenden Schicht mindestens eine Lochinjektionsschicht aufbringt.

Das erfindungsgemäße Verfahren wird im folgenden anhand einer besonders bevorzugten Ausführungsform ausführlich beschrieben. Demnach bringt man auf einem Substrat, vorzugsweis Glas, als 1. Elektrode eine Anode auf. Als Anodenmaterial wird vorzugsweise ITO eingesetzt. Nach dem Aufbringen des ITO's wird die Elektrode mittels Photolithographie oder anderen Ätzverfahren strukturiert. Nach der Strukturierung erfolgt vorzugsweise ein Reinigungsschritt. Daran schließt sich die Anodenmetallisierung, beispielsweise mittels eines Aufdampfprozesses oder eines Sputterprozesses an. Anschließend kann wieder eine Zwischenreinigung durchgeführt werden, bevor mittels Spincoat-Prozessen oder Druckprozessen eine Lochinjektionsschicht, beispielsweise aus PEDOT oder PANI, und anschliessend mindestens eine organische licht-emittierende Schicht aufgebracht wird. Danach wird die Kathode aufgedampft und anschließend wird das OLED mit einem Deckglas verkapselt.

Ein weiterer Gegenstand der vorliegenden Erfindung betrifft die Verwendung der erfindungsgemäßen OLED's in Beleuchtungsvorrichtungen. Der Begriff Beleuchtungsvorrichtungen umfasst dabei beispielsweise allgemeine Beleuchtung sowie Hintergrundbeleuchtung von LCD's.

In diesem Zusammenhang ist anzumerken, dass die Anforderung an die Homogenität einer Hintergrundbeleuchtung bei LCD's sehr hoch ist. Gerade diese Homogenität wird durch die vorliegende Erfindung gewährleistet. Darüber hinaus hat man durch die flexiblen Schaltungsmöglichkeiten, z.B. Einzelansteuerung, Reihenschaltung oder Matrixschaltung, die Möglichkeit die Hintergrundbeleuchtung mittels der erfindungsgemäßen OLED's modular in großflächigen LCD's einzusetzen.

Aufgrund ihrer Ausgestaltung lassen sich die erfindungsgemäßen OLED's nämlich sowohl einzeln als auch in Reihe geschaltet einsetzen. Auch ist die Kombination mehrerer Reihenschaltungen zu sogenannten "Matrixschaltungen" möglich.

Die Erfindung wird im folgenden anhand von Ausführungsbeispielen und Zeichnungen näher beschrieben, ohne dadurch jedoch beschränkt zu werden.

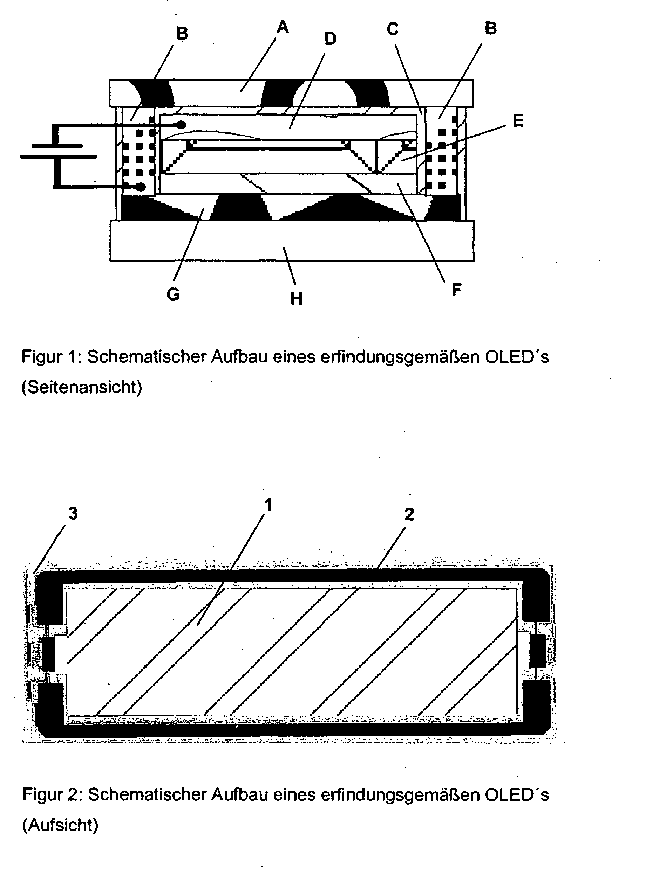

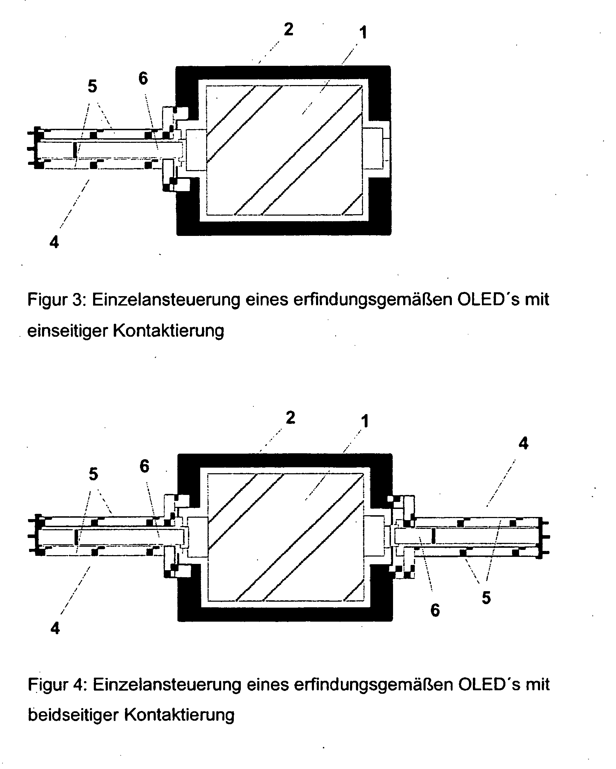

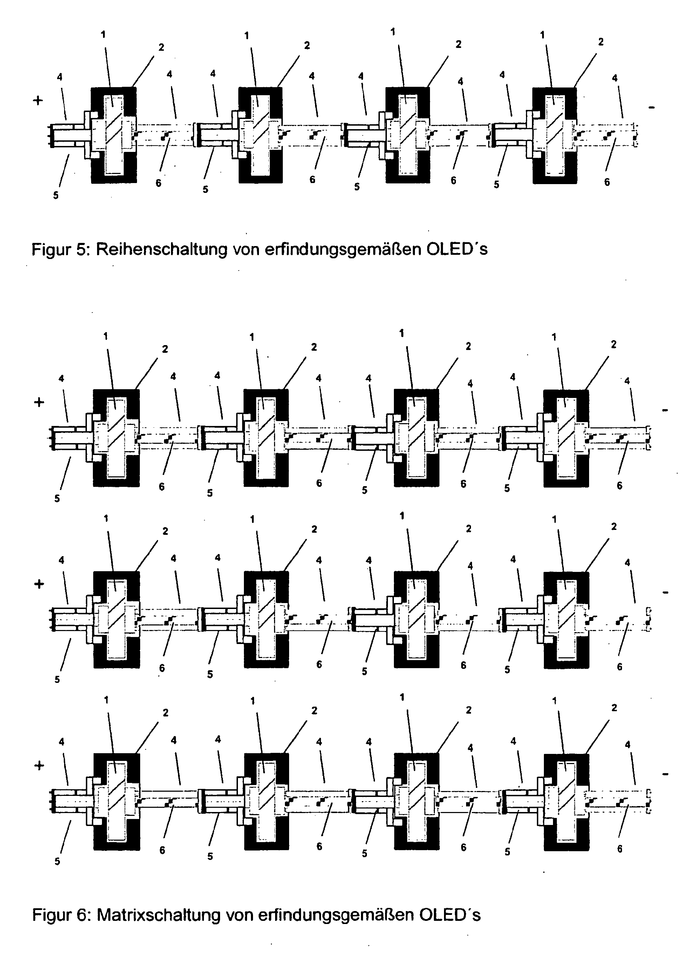

Die einzelnen Figuren zeigen dabei:
- den schematischen Aufbau eines erfindungsgemäßen OLED's sowohl in Seitenansicht (Figur 1) als auch in Aufsicht (Figur 2);
- die Einzelansteuerung eines erfindungsgemäßen OLED's sowohl mit einseitiger Kontaktierung (Figur 3) als auch mit beidseitiger Kontaktierung (Figur 4);
- eine Reihenschaltung von erfindungsgemäßen OLED's (Figur 5); und
- eine Matrixschaltung von erfindungsgemäßen OLED's (Figur 6).

### Bezugszeichenliste

| | |
|---|---|
| (A) | Deckglas |
| (B) | Leitende Schicht (z.B. Anodenmetallisierung) |
| (C) | Kleber |
| (D) | Kathode |
| (E) | Organische licht-emittierende Schicht |
| (F) | Lochinjektionsschicht (PEDOT; ^{®}Baytron P) |
| (G) | ITO (Indium-Zinnoxid) |
| (H) | Glassubstrat (Trägermaterial) |
| (1) | Kathode |
| (2) | Anodenmetallisierung |
| (3) | ITO layer inkl. Glassubstrat |
| (4) | FPC (flexible printed circuit) |
| (5) | FPC Anodenkontakt |
| (6) | FPC Kathodenkontakt |

### Beispiel 1:

### Herstellung eines erfindungsgemäßen OLED's

Auf einem Glassubstrat (Dicke: 0,7 mm) mit einem Brechungsindex von n [589 nm] ~ 1,5 wird eine ca. 130 nm dicke ITO Schicht als Anode (n = 1,8) aufgesputtert. Mittels eines Aufdampfprozesses und unter Einsatz einer entsprechenden Schattenmaske wird eine dünne Anodenmetallschicht aus Cr/Cu (50 nm/500 nm) auf die ITO-Schicht aufgebracht.

Darauf bringt man eine ca. 50 nm dicke PEDOT (Poly(3,4-ethylendioxythiophen)) Schicht (Baytron P AL4083) als LochInjektionsschicht auf. Auf dieser Schicht wird mittels Spin-Coating eine ca. 80 nm dicke Emitterschicht ("Super Yellow" oder SPW-093, Merck OLED Materials GmbH) aufgebracht. Als Kathode werden eine dünne Bariumschicht und darauf eine dickere (ca. 100 nm) Aluminiumschicht im Vakuum aufgedampft. Zuletzt wird das OLED noch durch vollflächiges Aufkleben einer Glasplatte verkapselt, um die Einflüsse von Sauerstoff und Luftfeuchtigkeit auf das OLED zu minimieren.

Figur 1 beschreibt den schematischen Aufbau des erfindungsgemäßen OLED's in Seitenansicht. Figur 2 zeigt eine Aufsicht des erfindungsgemäßen OLED's.

Wie insbesondere aus der Figur 2 zu ersehen ist, weist das erfindungsgemäße OLED in einer besonders bevorzugten Ausführungsform in zwei Richtungen (x- und y-Achse) einen achsensymmetrischen Aufbau auf. Ein solcher Aufbau hat folgende Vorteile:
1.) Die außen liegende Anodenmetallschicht, die die Kathode umgibt, ist zum einen Zuleitungs- und Transportschicht, die die Spannung möglichst verlustfrei über die gesamte Fläche in die ITO-Schicht einbringen soll, was zu einer homogeneren Emission führt und zum anderen Kontaktfläche für mögliche Steckersysteme, wie z.B. FPC (Flexible Printed Circuit), ist.
2.) Umrandet von der Anodenmetallschicht befindet sich in einer separaten Schicht in der Mitte die Kathode, deren Struktur die Leuchtfläche definiert.
3.) Das OLED kann beispielsweise als Einzelansteuerung (Beispiele 2 und 3), als Reihenschaltung ("Durchschleifen" der OLED's, Beispiel 4) oder als Matrixschaltung verwendet werden (Beispiel 5).

### Beispiel 2:

### Einzelschaltung eines erfindungsgemäßen OLED's mit einseitiger Ansteuerung

Zum Betreiben des einzelnen, in Beispiel 1 hergestellten OLED's, wird dieses auf einer Seite mit einer FPC-Kontaktierung (FPC = flexible printed circuit) versehen. Dazu wird das FPC mittels einer ACF-Folie (ACF = adhesive conductive foil) in einem Standard-Verfahren "aufgeklebt".

Das FPC ist dabei so aufgebaut, dass auf einem Kunststoff-Trägermaterial eine dünne, strukturierte Cu-Schicht aufgebracht ist und darauf eine Kunststoffschicht als Abdeckschicht. Die Kontaktflächen des FPC bleiben nicht isoliert, um mit den Kontaktflächen des OLED verbunden zu werden.

Figur 3 zeigt beispielhaft ein OLED, welches auf einer Seite eine FPC-Kontaktierung aufweist.

Die Anodenmetallisierung führt bei einseitiger Ansteuerung zu einer Uniformität der Lichtemission von weniger als 30% (Defintion: +/-Uniformität [%] = ((Leuchtdichte max- Leuchtdichte min)/2/Leuchtdichte average)*100 %.

### Beispiel 3:

### Einzelschaltung eines erfindungsgemäßen OLED's mit beidseitiger Ansteuerung

Zum Betreiben des einzelnen, in Beispiel 1 hergestellten OLED's, wird dieses auf zwei Seiten jeweils mit einer FPC-Kontaktierung (FPC = flexible printed circuit) versehen. Die Kontaktierung erfolgt dabei wie in Beispiel 2 beschrieben. Die beiden FPC's werden parallel angeschlossen.

Figur 4 zeigt das erfindungsgemäße OLED, welches auf zwei Seiten FPC-Kontaktierungen aufweist.

Durch die auf gegenüberliegenden Seiten angebrachten FPC-Kontaktierungen wird die Uniformität der Lichtemission im Vergleich zu Beispiel 2 weiter verbessert.

### Beispiel 4

### Reihenschaltung

Hierzu werden mehrere der in Beispiel 1 hergestellten OLED's in Reihe geschaltet. Dazu werden die einzelnen OLED's über FPC's miteinander verbunden. Dabei wird jeweils die Kathode eines OLED's mit der Anode des nächsten OLED's verbunden. Hierbei ist keine bauliche Veränderung der einzelnen OLED's notwendig. Lediglich die FPC's müssen entsprechend angepasst werden. Auf diese Weise werden alle OLED's mit dem gleichen Strom betrieben.

Figur 5 zeigt beispielhaft mehrere in Reihe geschaltete, erfindungsgemäße OLED's, die über FPC's miteinander verbunden sind.

Da bei einer Reihenschaltung die Gefahr besteht, dass bei einem Kontaktproblem alle OLED's ausfallen, kann man parallel zu den OLED's noch sogenannte "shunt"-Widerstände einbauen, die bei einer Unterbrechung des Stromes in einem oder mehreren OLED's deren Leitfähigkeit übernehmen.

### Beispiel 5

### Matrixschaltung

Hierzu werden mehrere in Reihe geschaltete OLED's zu einer Matrix verschaltet. Dabei werden nicht nur die einzelnen OLED's mittels FPC's miteinander verschaltet sondern auch die verschiedenen Reihenschaltungen. Die Ansteuerung kann dabei entweder über Passiv-Matrixansteuerung oder über Aktiv-Matrixansteuerung erfolgen.

Figur 6 zeigt beispielhaft eine Passiv-Matrixansteuerung, bei der mehrere Reihenschaltungen von OLED's mittels FPC's in einer Matrix geschaltet sind.

## Patentansprüche

1. OLED, das mindestens
- ein Substrat (H),
- eine Anode (G) mit zwei Zuleitungen,
- mindestens eine organische licht-emittierende Schicht (E), und
- eine Kathode (D) mit zwei Zuleitungen aufweiset,
wobei zumindest entweder
- das Substrat und die Anode,
- die Kathode oder
- das Substrat, die Anode und die Kathode transparent sind, wobei auf der Anode mindestens eine leitende Schicht (B), die eine Metallschicht ist, derart angeordnet ist, dass bei der leitenden Schicht die Struktur der Kathode ausgespart ist und dass die leitende Schicht die Strukur der Kathode im wesentlichen umgibt, wobei die Stellen der zwei Zuleitungen der Kathode ausgespart werden und wobei anodenseitig direkt an der mindestens einen organischen licht-emittierenden Schicht mindestens eine Lochleiterinjektionsschicht (F) angeordnet ist.

2. OLED nach Anspruch 1, **dadurch gekennzeichnet, dass** die Kathode transparent ist.

3. OLED nach Anspruch 1, **dadurch gekennzeichnet, dass** das Substrat, die Anode und die Kathode transparent sind.

4. OLED nach mindestens einem der Ansprüche 1 bis 3, **dadurch gekennzeichnet, dass** auf der der licht-emittierenden Schicht gegenüberliegenden Seite der Kathode zusätzlich noch eine Verkapselung angeordnet ist.

5. OLED nach mindestens einem der Ansprüche 1 bis 4, **dadurch gekennzeichnet, dass** das Substrat aus Glas besteht.

6. Verfahren zur Herstellung von OLED's nach mindestens einem der Ansprüche 1 bis 5, **dadurch gekennzeichnet, dass** man auf ein Substrat (H) eine Anode (G) mit zwei Zuleitungen, mindestens eine organische licht-emittierende Schicht (E) und eine Kathode (D) mit zwei Zuleitungen aufbringt, **dadurch gekennzeichnet, dass** man auf der Anode mindestens eine leitende Schicht (B), die eine Metallschicht ist, derart aufbringt, dass bei der leitenden Schicht die s Struktur der Kathode ausgespart ist und dass die leitende Schicht die Struktur der Kathode im wesentlichen umgibt, wobei die Stellen der zwei Zuleitungen der Kathode ausgespart werden und dass man anodenseitig direkt auf der mindestens einen organischen licht-emittierenden Schicht mindestens eine Lochleiterinjektionsschicht (F) aufbringt.

7. Verwendung von OLED's nach mindestens einem der Ansprüche 1 bis 5 in Beleuchtungsvorrichtungen.

## Claims

1. OLED which has at least
- a substrate (H),
- an anode (G) having two leads,
- at least one organic light-emitting layer (E), and
- a cathode (D) having two leads,
where at least either
- the substrate and the anode,
- the cathode or
- the substrate, the anode and the cathode are transparent,
where at least one conductive layer (B), which is a metal layer, is arranged on the anode in such a way that the structure of the cathode is cut out of the conductive layer and that the conductive layer essentially surrounds the structure of the cathode, where the positions of the two leads of the cathode are cut out and where at least one hole-conductor injection layer (F) is arranged directly on the anode side of the at least one organic light-emitting layer.

2. OLED according to Claim 1, **characterised in that** the cathode is transparent.

3. OLED according to Claim 1, **characterised in that** the substrate, the anode and the cathode are transparent.

4. OLED according to at least one of Claims 1 to 3, **characterised in that** an encapsulation is additionally arranged on the side of the cathode opposite the light-emitting layer.

5. OLED according to at least one of Claims 1 to 4, **characterised in that** the substrate consists of glass.

6. Process for the production of OLEDs according to at least one of Claims 1 to 5, **characterised in that** an anode (G) having two leads, at least one organic light-emitting layer (E) and a cathode (D) having two leads are applied to a substrate (H), **characterised in that** at least one conductive layer (B), which is a metal layer, is applied to the anode in such a way that the structure of the cathode is cut out of the conductive layer and that the conductive layer essentially surrounds the structure of the cathode, where the positions of the two leads of the cathode are cut out, and **in that** at least one hole-conductor injection layer (F) is applied directly to the anode side of the at least one organic light-emitting layer.

7. Use of OLEDs according to at least one of Claims 1 to 5 in lighting devices.

## Revendications

1. OLED qui comporte au moins:
- un substrat (H),
- une anode (G) comportant deux connexions,
- au moins une couche émettrice de lumière organique (E), et
- une cathode (D) comportant deux connexions,
où au moins
- soit le substrat et l'anode,
- soit la cathode,
- soit le substrat, l'anode et la cathode est/sont transparents,
où au moins une couche conductrice (B), qui est une couche en métal, est agencée sur l'anode de telle sorte que la structure de la cathode soit ôtée par découpe de la couche conductrice et que la couche conductrice entoure essentiellement la structure de la cathode, où les positions des deux connexions de la cathode sont ôtées par découpe et où au moins une couche d'injection conductrice de trous (F) est agencée directement sur le côté d'anode de l'au moins une couche émettrice de lumière organique.

2. OLED selon la revendication 1, **caractérisée en ce que** la cathode est transparente.

3. OLED selon la revendication 1, **caractérisée en ce que** le substrat, l'anode et la cathode sont transparents.

4. OLED selon au moins l'une des revendications 1 à 3, **caractérisée en ce qu'**une encapsulation est additionnellement agencée sur le côté de la cathode opposé à la couche émettrice de lumière.

5. OLED selon au moins l'une des revendications 1 à 4, **caractérisée en ce que** le substrat est constitué par du verre.

6. Procédé pour la production d'OLED selon au moins l'une des revendications 1 à 5, **caractérisé en ce qu'**une anode (G) comportant deux connexions, au moins une couche émettrice de lumière organique (E) et une cathode (D) comportant deux connexions sont appliquées sur un substrat (H), **caractérisé en ce qu'**au moins une couche conductrice (B), qui est une couche en métal, est appliquée sur l'anode de telle sorte que la structure de la cathode soit ôtée par découpe de la couche conductrice et que la couche conductrice entoure essentiellement la structure de la cathode, où les positions des deux connexions de la cathode sont ôtées par découpe, et **en ce qu'**au moins une couche d'injection conductrice de trous (F) est appliquée directement sur le côté d'anode de l'au moins une couche émettrice de lumière organique.

7. Utilisation d'OLED selon au moins l'une des revendications 1 à 5 dans des dispositifs d'éclairage.
